# EUROPEAN PATENT APPLICATION

(11) **EP 0 651 516 A1**
(43) Date of publication of application: **03.05.1995**
(21) Application number: 94306828.8
(22) Date of filing: 19.09.1994
(51) Int. Cl.: H03L 7/085

(54) **Clock synchronisation**

(30) Priority: 02.11.1993 GB 9322609
(71) Applicant: PLESSEY SEMICONDUCTORS LIMITED, Swindon, Wiltshire SN2 2QW (GB)
(72) Inventor: Bird, Philips Harvey, Highworth, Wiltshire (GB)
(74) Representative: Hoste, Colin Francis

(57) **Abstract**

A teletext clock synchronisation circuit in which the teletext signal is supplied as one input to an XOR gate and a clock signal at half the teletext signal frequency is applied to the XOR gate as its other input. The resulting output from the XOR gate is applied to an accumulator with a fixed number of teletext signal cycles and the accumulated value in the accumulator is used to alter the phase of the signal to be used to sample the teletext signal relative to the phase of the teletext signal.

## Description

This invention relates to the synchronisation of clock signals, particularly in teletext or programme delivery control decoding systems.

Teletext or programme delivery control (PDC) systems operate by sending digital data with a television signal, the digital data being transmitted between the lines of picture information carried by the television signal. The data is sent as a series of digital data lines at a fixed clock rate (generally 6.9375 MHz) and these data lines are interleaved between picture signal lines. The data is sampled by a data decoder clocked at the same frequency to extract the digital data from the TV signal. A problem with these systems is that the data clock rate is not linked in phase to any part of the TV picture signal and as a result the clock signal used by the data decoder in each television must synchronise itself with the received data signal.

PDC is a specialised form of teletext in which the teletext data includes 'labels' indicating the start and stop of programmes to control video recorders.

In order to allow this synchronisation each data line starts with a clock "run in" consisting of 8 bits of alternating ones and zeroes and the data decoder must be able to recognise the clock run in and adjust the phase of the clock signal to be used for sampling the data line to have the optimum phase relationship with the teletext data line. Known systems for teletext clock synchronisation operate by counting the edges of the incoming run in signal and after four bits find the next edge, the sampling phase to be used by the teletext decoder on the teletext data is then taken as starting two 6.9375 MHz clock cycles following this edge. This phase is then used for sampling the full line of teletext data.

This technique is not always reliable because it is totally dependent on the leading edge of the fifth bit being perfect and the quality and accuracy with which this single edge is received determines the effectiveness of data sampling for the whole line of teletext data. If any noise or interference or sampling errors corrupt this fifth edge the whole line of teletext data can be lost and as a result systems of this type are very sensitive to interference and noise. As a result it is quite possible that the relative phases of the teletext data clocking rate and the teletext decoder clock cannot be arranged to be an optimum for accurate sampling.

A further problem with this system is that it can work only on signals having an equal mark to space ratio and as a result can only carry out a phase adjustment based on the initial clock run in signal and cannot be used to adjust the clock phases during reception of the actual teletext data because the teletext data has a variable mark to space ratio.

This invention was intended to provide a clock sychronisation system overcoming these errors, at least in part.

This invention provides a clock phase synchronisation circuit comprising an XOR gate to which a data signal is supplied as one input and a first clock signal at half the data signal frequency is applied as the other input, an accumulator and a clock generator in which; the output of the XOR gate is supplied to the accumulator over a fixed number of data signal cycles so that the accumulator generates a number related to the relative phases of the data and first clock signals, and this number is supplied to the clock generator which adjusts the phase of a second clock signal at the data signal frequency and used to clock sampling of the data signal in dependence on the number.

Embodiments of the invention will now be described by way of example only with reference to the accompanying figures in which;
Figure 1 shows a teletext clock synchronisation circuit employing the invention,
Figure 2 shows some waveforms found in the circuit of Figure 1,
Figure 3 shows a graph of phase difference against output for the circuit of Figure 1,
Figure 4 shows a second teletext clock synchronisation circuit employing the invention; and
Figure 5 shows some waveforms found in the circuit of Figure 4, similar parts having the same reference numerals throughout.

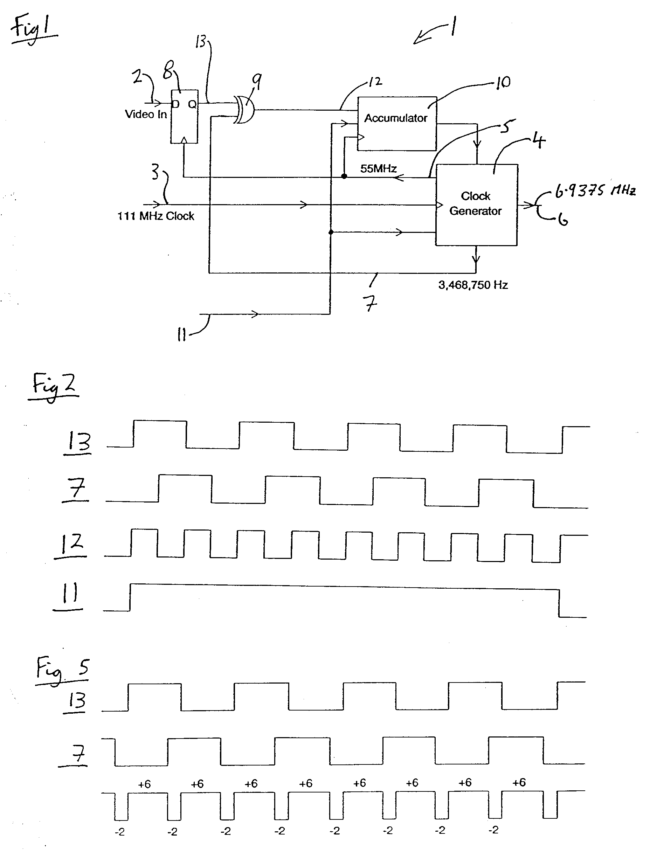

Referring to Figure 1 a teletext clock synchronisation circuit 1 is shown. This circuit would be equally applicable to a PDC system. The circuit 1 is supplied with an input video signal, which is an analogue video signal which has been sliced in a data slicer to produce a digital signal, along a line 2 and a 111 MHz clock signal from a local clock along a line 3. A data slicer is a one bit analogue to digital (A to D) converter. The 111 MHz clock signal is supplied by line 3 to a clock generator 4 which divides it to produce a 55.5 MHz clock signal on a line 5, a 6.9375 MHz output signal on a line 6 and a 3.46875 MHz clock signal on a line 7. The 111 MHz signal is divided by 2 to produce the 55.5 MHz signal, and by 16 to generate the 6.9375 MHz signal. The 6.9375 MHz signal is then divided by 2 to generate the 3.46875 MHz signal, as a result the 6.9375 MHz and 3.46875 MHz signals have a fixed phase relationship. The 6.9375 MHz signal on line 6 is the output clock signal used to clock the teletext decoder as it reads the incoming teletext data and this can have any one of 32 phases since it can be based on any of the 32 rising and falling edges of the 111 MHz clock signal from which it is derived.

The clock run in portion of the teletext data line can easily be detected because its time position in each TV signal line is defined relative to the TV line synchronisation pulses. This timing is accurate enough to allow the clock run in to be easily found but is not precise enough to allow the precise phase of the clock run in and teletext data to be predicted from the TV line sychronisation pulses. Although the clock run in is normally referred to as having 8 bits, in practice it comprises 12 to 16 bits because the first few bits of the clock run in cannot be safely used as a basis for clock synchronisation and are used simply as a signal that the clock run in is about to start leaving 8 bits whose transmitted phase and amplitude can be relied upon in systems with the minimum of 12 bits. There may also be up to four further bits in some systems after these 8.

When the first bits of the clock run in are detected the analogue video input signal is supplied along line 2 to the clock synchronisation system 1. The analogue video input along line 2 is supplied to a D type latch 8 which samples the incoming sliced video signal at 55.5 MHz, clocked by the 55.5 MHz signal on line 5, and the resulting digital output is applied to one input of an exclusive or (XOR) gate 9 along a line 13. The other input of the XOR gate 9 is the 3.46875 MHz signal on line 7. The output from the XOR gate 9 is then supplied to an accumulator 10 along a line 12.

The accumulator 10 is also supplied with the 55.5 MHz clock signal from line 5 and with an enabling signal along a line 11 indicating the start and finish of the clock run in, the signal on line 11 being high when the clock run in is being received and low at all other times. When the enabling signal on the line 11 goes from low to high the accumulator 10 is enabled and begins accumulating and when the enabling signal on line 11 goes from high to low the accumulator 10 stops accumulating and passes its accumulated value to the clock generator 4.

The XOR gate 9 will act as a phase comparitor comparing the phases of the clock run in signal from the D type latch 8 and the 3.46875 MHz signal along the line 7.

Ideally we want the 6.9375 MHz output signal on line 6 used to clock the teletext decoder to be 90° (π/2) out of phase with the clock run in and the teletext data line so that sampling of the teletext data always occurs in the centre of each bit which, will give the most reliable sampling, as is well known in data processing.

When the clock run in signal and the 3.46875 MHz signal on line 7 are 90° out of phase the output from the XOR gate 9 along line 12 will be a square wave at 6.9375 MHz having a mark to space ratio of 1:1 exactly. The signals on lines 7, 11, 12 and 13 in this case are shown in Figure 2. The accumulator 10 is arranged to count up 1 each time it receives a 55.5 MHz clock signal along the line 5 and its input along line 12 is high and to count down 1 every time it receives a 55.5 MHz clock signal along line 5 and its input along line 12 is low. As a result the numerical value generated by the accumulator when the signals are on lines 7 and 13 are exactly 90° out of phase will be zero and a positive or negative number will be generated depending on whether the two signals are more or less than 90° out of phase. The enable signal along line 11 always enables the accumulator 10 for 8 bits (4 ones and 4 zeros) of the clock run in so the final number produced by the accumulator can be divided by 4 and then used directly to adjust the phase of the 6.9375 MHz clock signal output along line 6.

If a different static phase relationship were required the accumulator count could be started from some number other than 1. The accumulator is stated at 1 rather than zero in order to round the phase charge to the nearest phase.

Where the value produced by the accumulator 10 is positive the phase of the clock signal needs to be advanced and if the number is negative the phase needs to be retarded.

If any one of the data bits in the clock run in is missing the output of the XOR gate 9 will revert to a square wave at the frequency of the input on line 7 and this will have no effect of the final accumulator value, as a result this system is immune to the effect of bits being missed in the clock run in due to interference or noise.

A possible source of error in teletext data decoders is the slice level of the initial data slicer or A to D converter being too high or too low. This can occur when bad reception conditions cause co-channel interference which produces a low frequency oscillation superimposed on the base band signal. The data slicer often has problems adapting to this oscillation, resulting in the sliced clock run in having an uneven mark to space ratio. This system is immune to this problem because it finds the centres of the bits in the input signal.

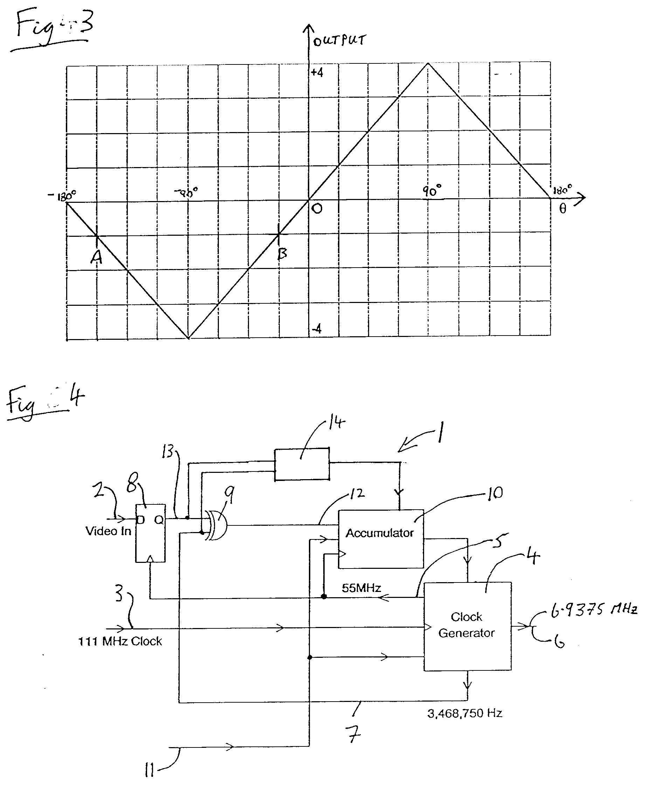

There is one source of phase uncertainty in this system which is that the XOR gate 9 acting as a phase comparator works only between +90° and -90° in phase, looking at Figure 3a graph of the characteristics of the XOR gate 9 output against the phase difference is shown. This graph shows the numerical count generated in the accumulator 10 by each cycle of the input video signal against phase difference. As can be seen this is a symmetric function giving the same output values for phase differences between zero and 90° as it does for phase differences between 90° and 180° with positive phase differences generating a positive output and negative phase differences a negative output. For example the two points A and B shown on the graph would both give the same output from the XOR phase comparitor 9 and accumulator 10 even though they correspond to entirely different phase differences.

This ambiguity can be eliminated by applying a system as shown in Figure 4. This is identical to the system of figure 1 except for the addition of a state logger 14. The states logger 14 looks at the signal state on the lines 7 and 13 and generates a signal indicating whether the reference clock signal on line 7 is low or high when the sampling data on line 13 makes a low to high (zero to one) transition. If the reference clock is low at this point we know that the phase difference must be in the +90° to - 90° range and the state logger output is zero, whereas if the reference clock is high at this time we know that the phase difference must be greater than 90° and the state logger output is one. When the accumulator 10 is informed that the phase difference is greater than 90° it subtracts the magnitude of each count value from 8 and leaves its sign unchanged before adding it to the accumulated total. Thus a count of - 1 would be altered to -7 or a count of +2 to +6. In order to make the state logger 14 noise resistent it is preferred to have it produce an output on every low to high change of the signal on line 13 throughout the clock run in period and have the accumulator 10 accumulate these signals also and assume that the majority high or low indication it produces over the whole clock run in period should be treated as the correct value. Thus if this accumulated value is 4 or less the accumulator assumes a phase difference in the range ± 90° and if it is 5 or more it assumes a phase difference of greater than 90°.

The accumulator 10 contains a 7 bit counter which stores 6 bits of data plus a sign bit. If, for example, the clock signal on line 7 was 45° ahead of its ideal position, i.e. 45° ahead of the clock run in signal, it follows that the 6.9375 MHz clock signal from which the 3.46875 MHz signal is derived must be 90° too fast and so it must be retarded 90°. Such a 90° retardation corresponds to 8 phases of the 111 MHz clock signal from which all the clock signals are derived (the 32 available phases of the 6.9375 MHz clock signal will be 11.25° of phase apart). In this situation, shown in Figure 5, the accumulator will count down 2 8 times and up 6 8 times giving a total of 32 and after removal of the last two bits to give a divide by 4 and rounding function, this will provide a value of 8 and so the 6.9375 MHz clock is advanced by 8 of its available phases to provide the best clocking of the teletext data line.

The worst possible case would be where the signal on line 7 is 90° out and thus the 6.9375 MHz clock is 180° out from its ideal position and in this case the accumulator will either count +8 8 times or -8 8 times to give a value of a + or - 64 (whether it counts -8 or +8 depends on whether it is very slightly less than 90° out of phase or very slightly more than 90° out of phase. After division this will provide a value of + or - 16 which will select the opposite phase for the 6.9375 MHz clock signal and since this is a complete phase reversal it does not matter whether this is done as a +16 or -16 change.

The phase of the transmitted teletext data signal will remain steady throughout a line of data so once the run in has been used to synchronise the teletext decoder clock signal to the teletext data line there should be no need for any further phase adjustment. However where a TV signal including teletext data is recorded on a video recorder it may well be found on playback that due to variations in tape speed the phase of the teletext data signal varies significantly in the course of one line of data. In order to allow continual adjustment of the teletext clock signal to correct for of such phase drift this synchronisation system could be allowed to operate throughout the data line instead of during the clock run in only. In this case it would of course be necessary to clear the accumulator periodically by providing an appropriate signal along line 11 at one eighth the teletext data clock frequency.

In practice although the phase of each teletext dataline cannot be deduced from the TV signal synchronisation pulses or from the phase of the previous teletext data line it has been found convenient in practice to have the clock generator 4 start each clock calibration operation for each teletext data line using the same phase of the 6.9375 MHz clock signal was decided on for the previous teletext data line because this will generally minimise the amount of phase shifting required since the phase of the teletext data tends to drift from teletext line to teletext line rather than varying randomly, although random variations cannot be ruled out.

## Claims

1. A clock phase synchronisation circuit comprising an XOR gate to which a data signal is supplied as one input and a first clock signal at half the data signal frequency is applied as the other input, an accumulator and a clock generator in which; the output of the XOR gate is supplied to the accumulator over a fixed number of data signal cycles so that the accumulator generates a number related to the relative phases of the data and first clock signals, and this number is supplied to the clock generator which adjusts the phase of a second clock signal at the data signal frequency and used to clock sampling of the data signal in dependence on the number.

2. A circuit as claimed in Claim 1 in which the data signal is a teletext signal.

3. A circuit as claimed in Claim 1 or Claim 2 in which state logging means are also provided which compare the data and first clock signals applied to the XOR gate and generate an output indicating whether the phase difference between them is in the range ± 90° or not.

4. A circuit as claimed in Claim 3 in which the phase of the second clock signal is adjusted in dependence on the number and the output of the state logging means.

5. A circuit as claimed in any preceding claim in which the accumulator is supplied with a third clock signal and increases its count by one each time it receives a clock pulse and the signal from the XOR gate is high and decreases its count by one each time it receives a clock pulse and the signal from the XOR gate is low.

6. A circuit as claimed in Claim 5 in which the data signal has a frequency of 6.9375 MHz and the third clock signal has a frequency of 55.5 MHz.
